Europäisches Patentamt

European Patent Office

Office européen des brevets

(19)

(11) Veröffentlichungsnummer: **0 492 050 A1**

## (12) EUROPÄISCHE PATENTANMELDUNG

(21) Anmeldenummer: **91113458.3**

(22) Anmeldetag: **10.08.91**

(51) Int. Cl.5: **H03H 11/04**

(30) Priorität: **22.12.90 DE 4041653**

(43) Veröffentlichungstag der Anmeldung:
**01.07.92 Patentblatt 92/27**

(84) Benannte Vertragsstaaten:
**DE FR GB IT NL**

(71) Anmelder: **ROBERT BOSCH GMBH**
**Postfach 30 02 20**
**W-7000 Stuttgart 30(DE)**

(72) Erfinder: **Bitar, Omar, Dipl.-Ing.**
**Marienfelder Allee 61**
**W-1000 Berlin 48(DE)**

(74) Vertreter: **Schmidt, Hans-Ekhardt, Dipl.-Ing.**
**Robert Bosch GmbH Geschäftsbereich**
**Mobile Kommunikation Patent- und**
**Lizenzabteilung Forckenbeckstrasse 9-13**
**W-1000 Berlin 33(DE)**

(54) **Aktives Hochpassfilter und aktives Tiefpassfilter.**

(57) 2.1 Ein bekanntes aktives Hochpaßfilter und aktives Tiefpaßfilter weist ein aktives Bandpaßfilter (120) auf, dem ein erstes Hochpaßfilter (160) bzw. ein erstes Tiefpaßfilter (130) zugeordnet ist. Das bekannte aktive Hochpaßfilter und das bekannte aktive Tiefpaßfilter sollen derart weitergebildet werden, daß mit diesen Filtern nur eine geringe Phasendrehung im Durchlaßbereich auftritt.

2.2 Die Lösung der Aufgabe besteht darin, daß zwischen dem Eingang (10) des aktiven Hochpaßfilters oder des aktiven Tiefpaßfilters und einem Eingang zur Arbeitspunkteinstellung (15) des aktiven Bandpaßfilters (12) ein zweites Hochpaßfilter (150) bzw. ein zweites Tiefpaßfilter (140) vorgesehen ist.

2.3 Ein bevorzugtes Anwendungsgebiet für ein erfindungsgemäßes aktives Tiefpaßfilter ist eine PLL-Schaltung, die durch die Verwendung des aktiven Tiefpaßfilters eine besonders geringe Einschwingzeit hat.

3. Die Zeichnung zeigt ein Schaltbild eines erfindungsgemäßen aktiven Tiefpaßfilters.

Fig. 2

EP 0 492 050 A1

Die Erfindung geht von einem aktiven Hochpaßfilter nach dem Oberbegriff des Anspruchs 1 und einem aktiven Tiefpaßfilter nach dem Oberbegriff des Anspruchs 2 aus.

Es ist ein aktives Hochpaßfilter und aktives Tiefpaßfilter bekannt (DE 34 21 645 A1), mit dem die Aufgabe gelöst wird, aus einem aktiven Bandpaßfilter durch Hinzufügen eines einfachen Netzwerkes mit Hochpaß- bzw. Tiefpaßverhalten ein aktives Hochpaß- oder Tiefpaßfilter zu bilden, das sich durch einen steilen Dämpfungsverlauf auszeichnet. Für bestimmte Anwendungen, zum Beispiel als Tiefpaßfilter in einer PLL-Schaltung, ist ein aktives Tiefpaßfilter der bekannten Art zwar geeignet; aber eine solche PLL-Schaltung hat eine verhältnismäßig große frequenzabhängige Phasendrehung und damit verbunden eine lange Einschwingzeit.

Der Erfindung liegt die Aufgabe zugrunde, ein aktives Hochpaßfilter oder ein aktives Tiefpaßfilter nach dem Oberbegriff der Ansprüche 1 und 2 derart weiterzubilden, daß sie in einem Teil des Durchlaßbereiches eine nur geringe oder keine Phasendrehung verursachen.

Diese Aufgabe wird bei einem aktiven Hochpaßfilter und einem aktiven Tiefpaßfilter gemäß dem Oberbegriff der Ansprüche 1 und 2 durch die im kennzeichnenden Teil dieser Ansprüche angegebenen Merkmale gelöst. Die mit der Erfindung erzielbaren Vorteile bestehen insbesondere darin, daß bei den Filtern eine extrem geringe Phasendrehung auftritt, die mit einem sehr geringen Aufwand, im einfachsten Fall mit einem zusätzlichen RC-Glied, erzielbar ist. Bei entsprechender Dimensionierung ist es sogar möglich, daß die Phasendrehung im Durchlaßbereich eines aktiven Hochpaßfilters oder Tiefpaßfilters den Phasenwinkel 0° überschreitet.

Wird ein erfindungsgemäßes aktives Tiefpaßfilter in einer PLL-Schaltung als Teil des Schleifenfilters angewendet, dann wird die Einschwingzeit der PLL-Schaltung erheblich reduziert, und zwar zum Beispiel um den Faktor 2 bis 4 gegenüber der Einschwingzeit einer PLL-Schaltung mit einem herkömmlichen aktiven Tiefpaßfilter (bei vergleichbarer Dämpfung des gesamten PLL-Filters). Ein weiterer, wesentlicher Vorteil des aktiven Hochpaßfilters und des aktiven Tiefpaßfilters besteht darin, daß diese Filter extrem wenig Rauschen verursachen im Vergleich zu den bekannten aktiven Filtern. Dieser Vorteil ist insbesondere bei der Verarbeitung von Signalen mit kleinem Pegel von Bedeutung. Der gleiche Vorteil ergibt sich auch beim Einsatz eines erfindungsgemäßen aktiven Tiefpaßfilters in einer PLL-Schaltung.

Ein Ausführungsbeispiel der Erfindung ist in der Zeichnung an Hand mehrerer Figuren dargestellt und wird im folgenden näher beschrieben.

Es zeigen

Fig. 1   ein Blockschaltbild eines erfindungsgemäßen aktiven Hochpaßfilters oder Tiefpaßfilters,

Fig. 2   ein komplettes Schaltbild eines aktiven Tiefpaßfilters,

Fig. 3   ein Diagramm, das die Spannungen U1, U2 in Abhängigkeit von der Frequenz zeigt,

Fig. 4   den Phasengang eines aktiven Bandpaßfilters des aktiven Tiefpaßfilters ohne zweites Tiefpaßfilter (A) und mit zweitem Tiefpaßfilter (B, C),

Fig. 5   ein Diagramm des Phasenverlaufs an den Schaltungspunkten P1 und P2 in Fig. 2,

Fig. 6   ein Diagramm, das die Ausgangsspannung $U_A$ des aktiven Tiefpaßfilters mit Zusatzkondensator und ohne Zusatzkondensator in Abhängigkeit von der Frequenz zeigt,

Fig. 7   einen Kurvenverlauf ($\Phi$1) des Phasenwinkels in Abhängigkeit von der Frequenz am Ausgang des aktiven Tiefpaßfilters ohne Zusatzkondensator (C5) und einen Kurvenverlauf ($\Phi$2) mit Zusatzkondensator,

Fig. 8   ein Blockschaltbild einer PLL-Schaltung mit erfindungsgemäßem aktiven Tiefpaßfilter und

Fig. 9   ein komplettes Schaltbild eines aktiven Hochpaßfilters.

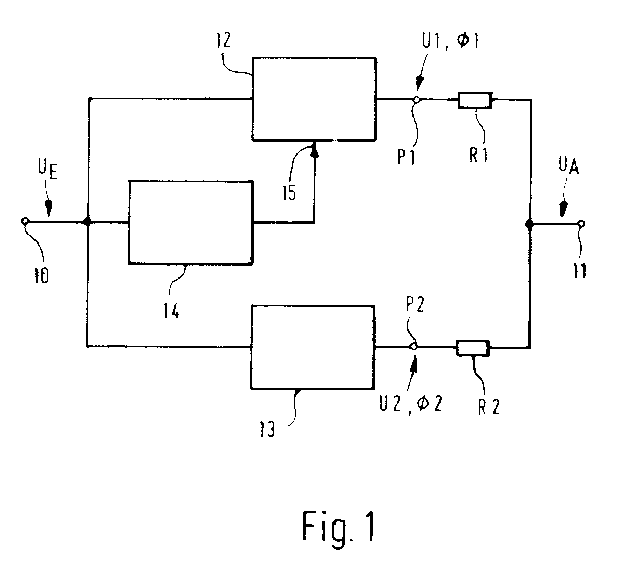

In dem Blockschaltbild eines erfindungsgemäßen aktiven Hochpaßfilters oder aktiven Tiefpaßfilters nach Fig. 1 bezeichnet 10 einen Eingang und 11 einen Ausgang des Filters. Der Eingang 10 steht erstens über ein aktives Bandpaßfilter 12 und einen ersten Widerstand R1, zweitens über ein erstes Netzwerk 13 und einen zweiten Widerstand R2 mit dem Ausgang 11 und drittens über ein zweites Netzwerk 14 mit einem Eingang 15 zur Einstellung des Arbeitspunktes des aktiven Bandpaßfilters 12 in Verbindung.

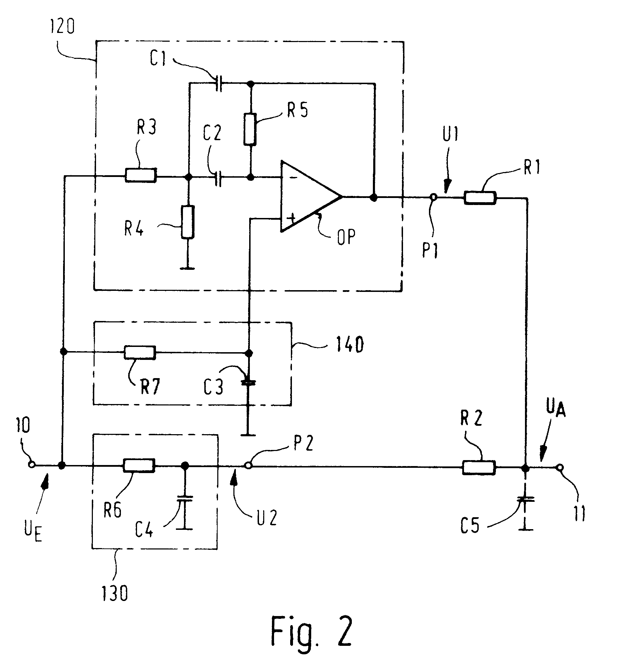

Ein ausführliches Schaltbild eines aktiven Tiefpaßfilters nach der Erfindung zeigt die Fig. 2. Der Eingang 10 ist erstens mit einem Bandpaßfilter 120 verbunden, dessen Eingang über einen ersten Widerstand R3 und einen Kondensator C2 mit dem invertierenden Eingang eines Operationsverstärkers OP verbunden ist. Zwischen dem Widerstand R3 und dem Kondensator C2 zweigt ein Widerstand R4 nach Masse und ein Kondensator C1 zum Ausgang P1 des Operationsverstärkers ab. Der Ausgang P1 ist über einen Widerstand R5 mit dem invertierenden Eingang des Operationsverstärkers OP verbunden. Zwischen dem Ausgang P1 des Operationsverstärkers und dem Ausgang 11 des aktiven Tiefpaßfilters liegt ein Widerstand R1. Der Eingang 10 des aktiven Tiefpaßfilters ist zweitens mit einem ersten Netzwerk, das ist ein erstes Tiefpaßfilter 130, verbunden, das aus einem RC-Glied R6, C4 besteht. Ein Ausgang P2 des ersten Tiefpaßfilters 130 ist über einen zweiten Widerstand R2 mit dem Ausgang 11 des aktiven Tiefpaßfilters verbunden. Von dem Eingang 10 des aktiven Tiefpaßfilters führt außerdem eine Verbindung zu einem zweiten Netzwerk, das ist ein zweites Tiefpaßfilter 140 aus einem RC-Glied R7, C3.

Ein Ausgang dieses Tiefpaßfilters ist mit dem nichtinvertierenden Eingang des Operationsverstärkers OP des aktiven Bandpaßfilters 120 verbunden. Mit C5 ist ein Kondensator bezeichnet, der wahlweise zwischen den Ausgang 11 des aktiven Tiefpaßfilters und Masse geschaltet werden kann.

Die Wirkungsweise eines kompletten aktiven Tiefpaßfilters nach Fig. 2 wird im einzelnen wie folgt beschrieben.

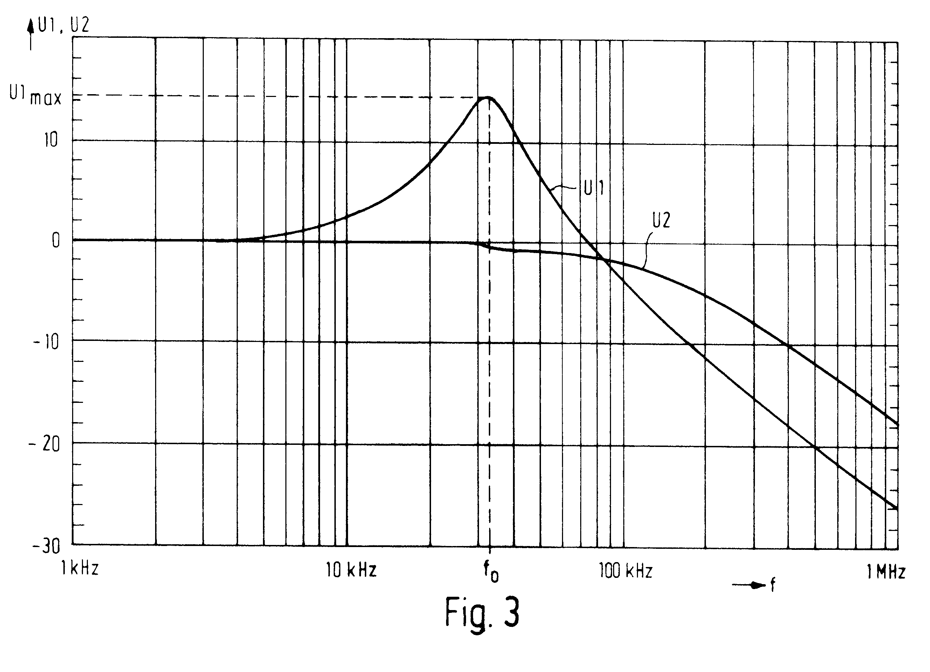

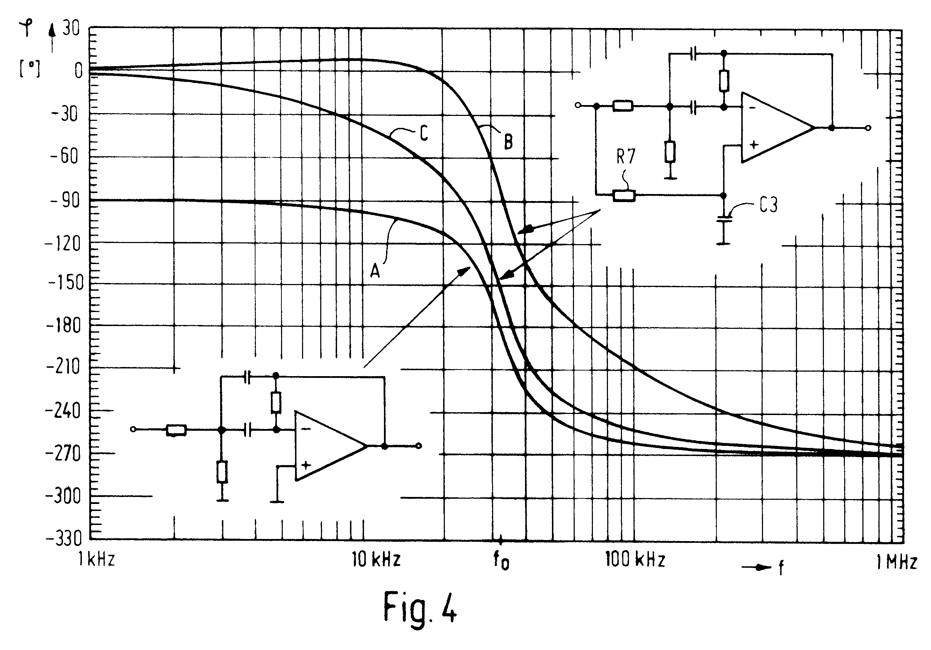

Am Eingang 10 des aktiven Bandpaßfilters 12, das eine verhältnismäßig geringe Güte von zum Beispiel 2 hat, liegt eine Wechselspannung $U_E$ der Frequenz f. Das aktive Bandpaßfilter 12 hat in Verbindung mit dem zweiten Tiefpaßfilter 140 einen in Fig. 3 mit U1 bezeichneten Amplitudenverlauf mit einem maximalen Amplitudenwert $U1_{max}$ bei einer Resonanzfrequenz $f_0$ von zum Beispiel 33 kHz. Oberhalb der Resonanzfrequenz $f_0$ nimmt die Spannung U1 mit zunehmender Frequenz stärker als unterhalb der Resonanzfrequenz ab (Fig. 3). Gleichzeitig nimmt der Phasenwinkel $\phi$ des Bandpaßfilters 12 ohne zweites Tiefpaßfilter 140 in negativer Richtung zu (Fig. 4A). Der Phasenverlauf nach Fig. 4A beginnt mit einem Phasenwinkel von -90° und endet bei -270°. Im Gegensatz dazu ergibt das Bandpaßfilter 12 in Verbindung mit dem zweiten Tiefpaßfilter 140 einen Phasenverlauf nach Fig. 4B, der mit einem Phasenwinkel von 0° beginnt und ebenfalls mit -270° endet; durch das zweite Tiefpaßfilter 140 findet also insbesondere im Durchlaßbereich eine zusätzliche, frequenzabhängige Phasenverschiebung in Richtung auf den Phasenwinkel 0° statt. Je nach der Dimensionierung des zweiten Tiefpaßfilters 140 ergibt sich zwischen den Phasenverläufen nach Fig. 4A und 4B sowie oberhalb des Phasenverlaufs nach Fig. 4B eine Vielzahl von Phasenverläufen, die alle mit dem Phasenwinkel 0° beginnen. Der Phasenverlauf in Fig. 4C ist ein Beispiel für einen derartigen Phasenverlauf.

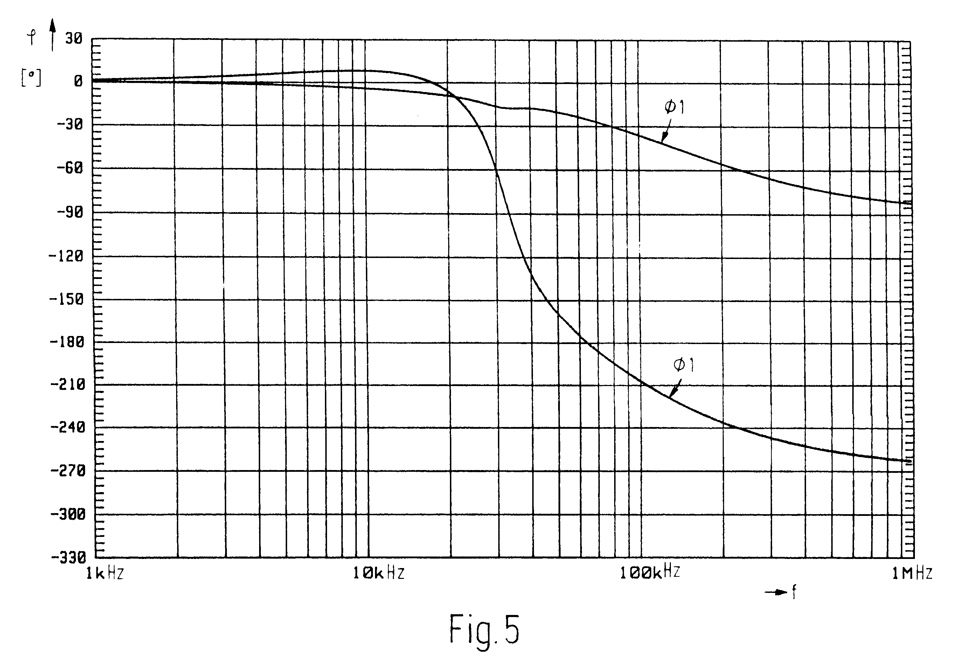

Betrachtet man in Fig. 3 die Ausgangsspannungen U1, U2 an den Ausgängen P1 und P2 (Fig. 2) gemeinsam, so geht daraus hervor, daß oberhalb der Resonanzfrequenz $f_0$ des aktiven Bandpaßfilters 120, das heißt zum Beispiel oberhalb von 200 kHz, die Spannungen U1 und U2 einen annähernd parallelen Verlauf haben. Die zugehörigen Phasengänge $\Phi1$ und $\Phi2$ nach Fig. 5 haben oberhalb von etwa 200 kHz einen ebenfalls weitgehend parallelen Verlauf mit einem Abstand von etwa 180°. Durch eine geeignete Wahl der Widerstände R1 und R2 (vgl. Fig. 2), durch die die unterschiedlichen Amplituden der Ausgangsspannungen U1 und U2 ab etwa 200 kHz berücksichtigt werden, findet in dem angegebenen Frequenzbereich eine weitgehende Auslöschung der Ausgangsspannung $U_A$ statt.

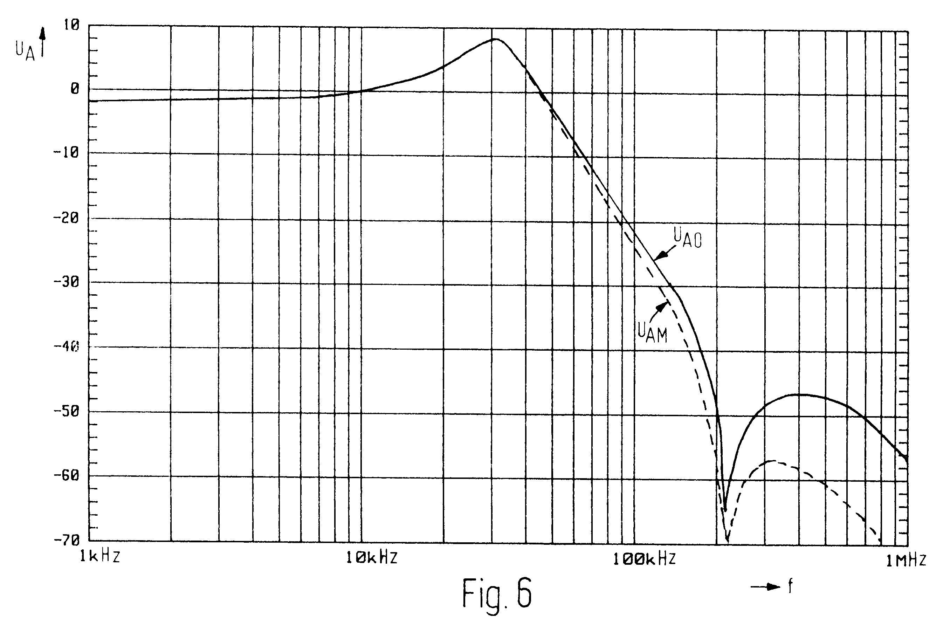

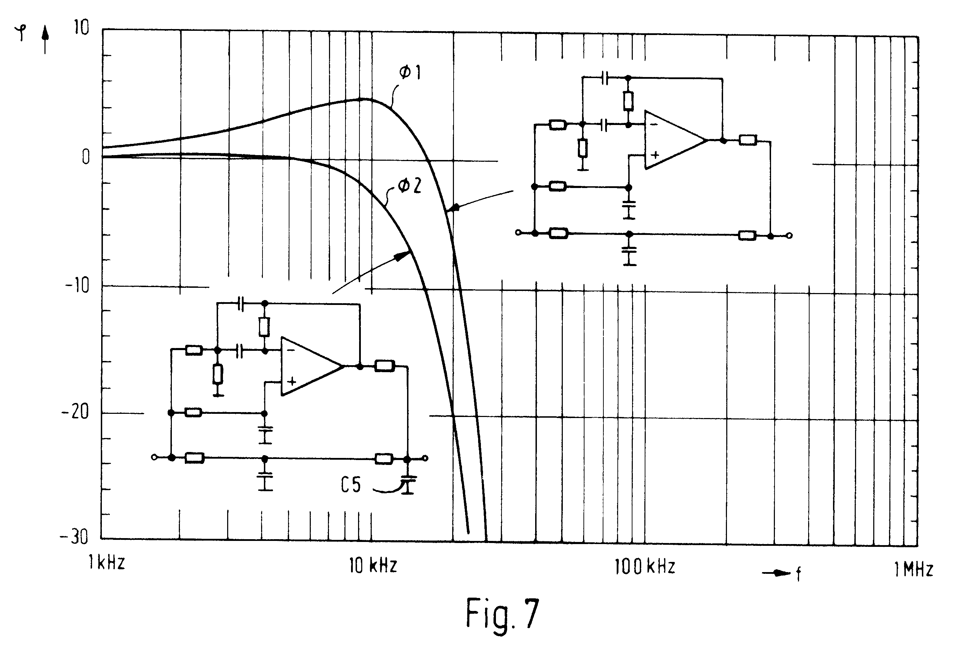

Der in Fig. 6 gezeigte Verlauf der Ausgangsspannung $U_{AO}$ in Abhängigkeit von der Frequenz f gilt für ein komplettes aktives Tiefpaßfilter nach Fig. 2 ohne den Kondensator C5. In Fig. 7 ist der zugehörige Phasenverlauf $\Phi1$ in Abhängigkeit von der Frequenz gezeigt. Aus der Fig. 7 geht deutlich hervor, daß bis zu etwa 17 kHz der Phasenverlauf zum größten Teil den Phasenwinkel 0° geringfügig überschreitet. In Fig. 6 ist durch eine gestrichelte Linie der Verlauf der Spannung $U_{AM}$ gezeigt, die sich ergibt, wenn in dem Schaltbild nach Fig. 2 der Kondensator C5 eingefügt ist, der den Dämpfungsverlauf im Sperrbereich beeinflußt. Der zugehörige Phasenverlauf $\Phi2$ ist in Fig. 7 gezeigt.

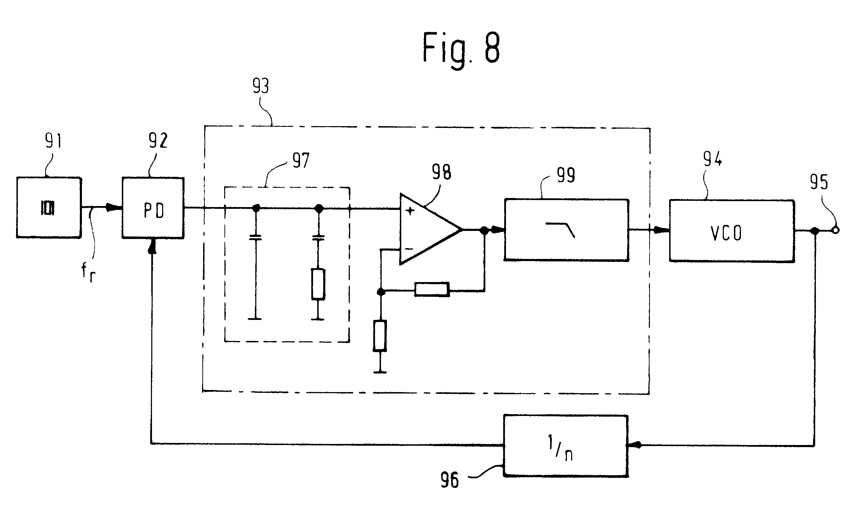

Ein bevorzugtes Anwendungsgebiet für ein aktives Tiefpaßfilter nach Fig. 2 ist eine PLL-Schaltung mit extrem schneller Einschwingzeit; vgl. Schaltbild in Fig. 8. Die PLL-Schaltung umfaßt einen Referenzfrequenzgenerator 91, der zum Beispiel eine Referenzfrequenz $f_r$ = 200 kHz aufweist, einen Phasendetektor 92, ein mit dessen Ausgang verbundenes PLL-Filter 93, einen spannungsgesteuerten Oszillator 94 und ein mit dem Ausgang 95 des spannungsgesteuerten Oszillators verbundenen Frequenzteiler 96 umfaßt, der mit einem Eingang des Phasendetektors 92 verbunden ist. Das PLL-Filter 93 besteht aus einer Reihenschaltung einer ersten Stufe 97 des PLL-Filters 93, einem Trennverstärker 98 und einer zweiten Stufe 99 des PLL-Filters. Die zweite Stufe entspricht dem erfindungsgemäßen aktiven Tiefpaßfilter.

Während bei der angenommenen Referenzfrequenz $f_r$ von 200 kHz mit einer Einschwingzeit einer PLL-Schaltung mit bekanntem Filter von etwa 500 $\mu s$ gerechnet werden muß, ist durch die Anwendung des aktiven Tiefpaßfilters 99 eine erhebliche Verkürzung der Einschwingzeit möglich. Für eine derart geringe Einschwingzeit ist die geringe Phasendrehung durch das aktive Tiefpaßfilter 99 verantwortlich. Ein weiterer wichtiger Vorteil des aktiven Tiefpaßfilters ist das verbesserte Rauschverhalten, das sich auch bei Anwendung in einer PLL-Schaltung vorteilhaft bemerkbar macht, und das bessere Spektrum des Ausgangssignals des Oszillators 94 bezüglich der Rauschunterdrückung sowie der Unterdrückung der Referenzfrequenz $f_r$ und deren Oberwellen.

In analoger Weise zu dem aktiven Tiefpaßfilter läßt sich auch ein entsprechendes aktives Hochpaßfilter realisieren, bei dem die Netzwerke 13 und 14 nach Fig. 1 Hochpaßfilter sind. Auch mit diesen Filtern ist im Durchlaßbereich ein Phasenwinkel von 0° erzielbar.

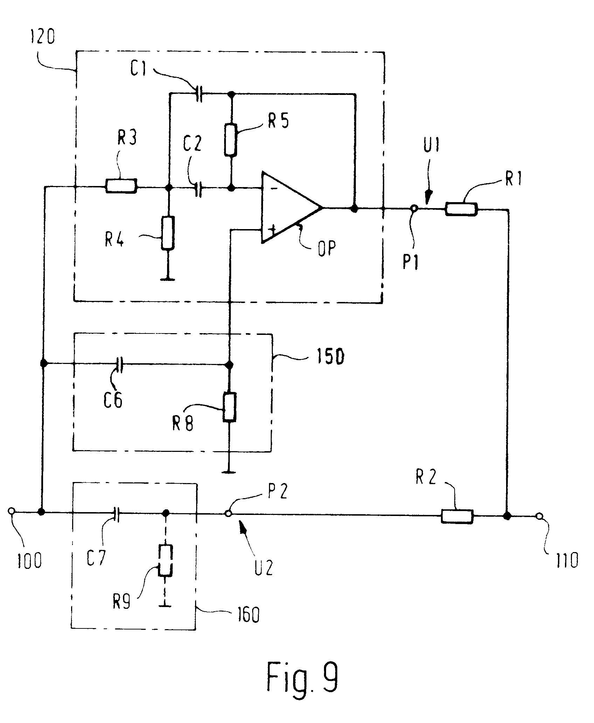

In Fig. 9, die ein komplettes Schaltbild eines aktiven Hochpaßfilters zeigt, bedeutet 120 ein aktives Bandpaßfilter wie in Fig. 2, dessen Eingang mit dem Eingang 100 des aktiven Hochpaßfilters verbunden ist. Zwischen dem Eingang 100 und dem nichtinvertierenden Eingang des Operationsverstärkers OP liegt ein zweites Hochpaßfilter 150 aus einem RC-Glied R8, C6. Zwischen dem Eingang 100 und dem Widerstand R2 liegt ein erstes Hochpaßfilter 160 aus einem RC-Glied C7, R9. Der in Fig. 9 gestrichelt gezeigte Widerstand R9 kann gegebenenfalls entfallen.

Die sich bei einem aktiven Hochpaßfilter nach Fig. 9 ergebenden Phasen- und Amplitudenverläufe sind spiegelbildlich zu der Resonanzfrequenz $f_0$ in den Fig. 3, 4 und 5.

Die Tiefpaßfilter 130, 140 (Fig. 2) sind vorzugsweise Filter ersten Grades. Das zweite Hochpaßfilter 150 (Fig. 9) ist vorzugsweise ebenfalls ein Filter ersten Grades.

## Patentansprüche

1. Aktives Hochpaßfilter mit einem aktiven Bandpaßfilter (12), dem ein erstes Hochpaßfilter (13) zugeordnet ist, dessen Eingang mit einem Eingang (10) des aktiven Hochpaßfilters und dessen Ausgang (P2) über zwei Widerstände (R2, R1) mit einem Ausgang (P1) des aktiven Bandpaßfilters (12) verbunden ist, wobei zwischen den beiden Widerständen (R1, R2) der Ausgang (11) des aktiven Hochpaßfilters liegt, **dadurch gekennzeichnet**, daß zwischen dem Eingang (10) des aktiven Hochpaßfilters und einem Eingang zur Arbeitspunkteinstellung (15) des aktiven Bandpaßfilters (12) ein zweites Hochpaßfilter (14) vorgesehen ist.

2. Aktives Tiefpaßfilter mit einem aktiven Bandpaßfilter (12), dem ein erstes Tiefpaßfilter (13) zugeordnet ist, dessen Eingang mit einem Eingang (10) des aktiven Tiefpaßfilters und dessen Ausgang (P2) über zwei Widerstände (R1, R2) mit einem Ausgang des aktiven Bandpaßfilters (12) verbunden ist, wobei zwischen den beiden Widerständen (R1, R2) der Ausgang (11) des aktiven Tiefpaßfilters liegt, **dadurch gekennzeichnet**, daß zwischen dem Eingang (10) des aktiven Tiefpaßfilters und einem Eingang zur Arbeitspunkteinstellung (15) des aktiven Bandpaßfilters (12) ein zweites Tiefpaßfilter (14) vorgesehen ist.

3. Aktives Hochpaßfilter nach Anspruch 1, dadurch gekennzeichnet, daß das erste Hochpaßfilter (160) ein Hochpaßfilter ersten Grades ist.

4. Aktives Hochpaßfilter nach Anspruch 1 oder 3, dadurch gekennzeichnet, daß das erste Hochpaßfilter (160) durch einen Kondensator (C7) ersetzt ist.

5. Aktives Tiefpaßfilter nach Anspruch 2, dadurch gekennzeichnet, daß das erste Tiefpaßfilter (130) ein Tiefpaßfilter ersten Grades ist.

6. Aktives Tiefpaßfilter nach Anspruch 5, dadurch gekennzeichnet, daß zwischen dem Ausgang (11) des aktiven Tiefpaßfilters und Masse ein zusätzlicher Kondensator (C5) liegt.

7. Aktives Hochpaßfilter nach einem der Ansprüche 1, 3 oder 4, dadurch gekennzeichnet, daß das zweite Hochpaßfilter (150) ein Hochpaßfilter ersten Grades ist.

8. Aktives Tiefpaßfilter nach einem der Ansprüche 2, 5 oder 6, dadurch gekennzeichnet, daß das zweite Tiefpaßfilter (140) ein Tiefpaßfilter ersten Grades ist.

9. Aktives Hochpaßfilter nach einem der Ansprüche 1, 3, 4 oder 7, dadurch gekennzeichnet, daß das aktive Bandpaßfilter (120) einen Operationsverstärker (OP) enthält, dessen nichtinvertierender Eingang mit dem Ausgang des zweiten Hochpaßfilters (150) verbunden ist.

10. Aktives Tiefpaßfilter nach einem der Ansprüche 2, 5, 6 oder 8, dadurch gekennzeichnet, daß das aktive Bandpaßfilter (120) einen Operationsverstärker (OP) enthält, dessen nichtinvertierender Eingang mit dem Ausgang des zweiten Tiefpaßfilters (140) verbunden ist.

11. Aktives Hochpaßfilter nach einem der Ansprüche 1, 3, 4 oder 7, dadurch gekennzeichnet, daß das Bandpaßfilter (120) eine Güte von etwa 2 hat.

12. Aktives Tiefpaßfilter nach einem der Ansprüche 2, 5, 6, 8 oder 10, dadurch gekennzeichnet, daß das Bandpaßfilter (120) eine Güte von etwa 2 hat.

Fig. 1

Fig. 2

Fig. 3

Fig. 4

Fig.5

EP 0 492 050 A1

Fig. 6

Fig.7

# Fig. 8

EP 0 492 050 A1

Fig. 9

Europäisches
Patentamt

**EUROPÄISCHER RECHERCHENBERICHT**

Nummer der Anmeldung

EP    91 11 3458

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | US-A-3 727 147 (K.I.DEWITT) 10. April 1973<br>* Spalte 2, Zeile 4 - Spalte 3, Zeile 25;<br>Abbildung 1 *<br>--- | 2 | H03H11/04 |
| Y | ELEKTOR ELECTRONICS.<br>Bd. 3, Nr. 6, Juni 1977, CANTERBURY GB<br>Seiten 35 - 36; 'Active Filters for the "filler driver" principle'<br>* das ganze Dokument *<br>--- | 2 | |
| D,A | DE-A-3 421 645 (BOSCH) 12. Dezember 1985<br>* das ganze Dokument *<br>--- | 1-12 | |
| A | GB-A-1 044 597 (BOFORS) 5. Oktober 1966<br>* das ganze Dokument *<br>--- | 3-5,7,8 | |
| A | ELEKTRONIK.<br>Bd. 36, Nr. 26, 23. Dezember 1987, MÜNCHEN DE<br>Seiten 112 - 114;<br>M.STITT U.A.: 'MÖGLICHKEITEN ZUR RAUSCHUNTERDRÜCKUNG'<br>* das ganze Dokument *<br>----- | 6 | **RECHERCHIERTE SACHGEBIETE (Int. Cl.5 )**<br><br>H03H |

Der vorliegende Recherchenbericht wurde für alle Patentansprüche erstellt

| Recherchenort | Abschlußdatum der Recherche | Prüfer |
|---|---|---|
| DEN HAAG | 02 APRIL 1992 | COPPIETERS C. |